# FASCICULE DE BREVET EUROPEEN

(11) **EP 4 492 459 B1**
(45) Date de publication et mention de la délivrance du brevet: **07.10.2026**
(21) Numéro de dépôt: 24184446.3
(22) Date de dépôt: 25.06.2024
(51) Int. Cl.: H10W 80/00, H10W 90/10, H10W 74/10

(54) **PROCÉDÉ DE PROTECTION DE COUCHES ACTIVES DE PUCES ÉLECTRONIQUES**
VERFAHREN ZUM SCHUTZ VON AKTIVEN SCHICHTEN ELEKTRONISCHER CHIPS
METHOD FOR PROTECTING ACTIVE LAYERS OF ELECTRONIC CHIPS

(30) Priorité: 09.07.2023 FR 2307330
(43) Date de publication de la demande: 15.01.2025
(73) Titulaire: Commissariat à l'Energie Atomique et aux Energies Alternatives, 75015 Paris (FR)
(72) Inventeur: BOURJOT, Emilie, 38054 Cedex 09 Grenoble (FR)
(74) Mandataire: INNOV-GROUP

(56) Documents cités:
- WO-A1-2022/239325
- US-A1- 2012 187 576
- US-A1- 2023 018 706
- BOURJOT E ET AL: "Towards a Complete Direct Hybrid Bonding D2W Integration Flow: Known-Good-Dies and Die Planarization Modules Development", 2019 INTERNATIONAL 3D SYSTEMS INTEGRATION CONFERENCE (3DIC), IEEE, 8 October 2019 (2019-10-08), pages 1 - 5, XP033749376, DOI: 10.1109/3DIC48104.2019.9058783

## Description

### Domaine technique

L'invention se rapporte au domaine technique de la protection de couches actives de puces électroniques.

L'invention trouve notamment son application dans la protection de couches actives réalisées en matériau(x) de type III-V pour des capteurs d'image.

### État de l'art

Un procédé de report puce à plaque (« *Die-to-Wafer*» en langue anglaise), connu de l'état de la technique, permet d'obtenir un empilement comprenant successivement :
- un substrat support ;
- une interface de collage hybride, possédant un matériau métallique et un matériau diélectrique ;
- des puces électroniques, assemblées au substrat support via l'interface de collage hybride, et comprenant chacune successivement une couche active, une couche diélectrique et un substrat initial.
US2023/018706/A1 divulgue un procédé de ce type comprenant les étapes de former une première couche d'encapsulation autour des puces électroniques, et d'effectuer un meulage de manière à retirer une partie du substrat initial de chacune des puces électroniques.

Le transfert d'un signal électrique est permis grâce à l'interface de collage hybride. Le procédé se poursuit classiquement par le retrait du substrat initial, généralement par meulage.

Or, un tel retrait du substrat initial par meulage n'est pas entièrement satisfaisant dans la mesure où il est susceptible de :
(i) dégrader la couche active (en particulier les flancs) ;
(ii) laisser subsister des résidus du substrat initial.

En particulier, le fait de laisser subsister des résidus du substrat initial peut être préjudiciable en termes de performances des puces électroniques pour une application de capteur d'images. En effet, les résidus du substrat initial vont conduire à des problèmes d'absorption de spectre.

### Exposé de l'invention

L'invention vise à remédier en tout ou partie aux inconvénients précités. A cet effet, l'invention a pour objet un procédé de protection de couches actives de puces électroniques, comportant les étapes successives :
a) utiliser un empilement comprenant successivement :
   - un substrat support ;
   - une interface de collage hybride, possédant un matériau métallique et un matériau diélectrique ;
   - des puces électroniques, assemblées au substrat support via l'interface de collage hybride, et comprenant chacune successivement une couche active, une couche diélectrique et un substrat initial ;
b) former une première couche d'encapsulation autour des puces électroniques, la première couche d'encapsulation étant réalisée dans un premier matériau diélectrique ;
c) effectuer un meulage de manière à retirer une partie du substrat initial de chacune des puces électroniques et conserver une partie restante dudit substrat initial ;
d) former une deuxième couche d'encapsulation autour des puces électroniques, la deuxième couche d'encapsulation étant réalisée dans un deuxième matériau diélectrique ;
e) effectuer une gravure directionnelle d'une partie de la deuxième couche d'encapsulation, s'étendant sur la partie restante du substrat initial de chacune des puces électroniques, de manière à :
   - exposer superficiellement la partie restante du substrat initial de chacune des puces électroniques ;
   - conserver la deuxième couche d'encapsulation s'étendant sur les flancs des puces électroniques ;
f) effectuer une gravure chimique sélective de la partie restante du substrat initial de chacune des puces électroniques ; l'étape f) étant exécutée avec un agent de gravure chimique autorisant une gravure sélective de la partie restante du substrat initial par rapport à la deuxième couche d'encapsulation et par rapport à la couche diélectrique.

Ainsi, un tel procédé selon l'invention permet de protéger efficacement la couche active lors du retrait du substrat initial, tout en réduisant significativement la quantité de résidus du substrat initial.

La protection de la couche active vis-à-vis du meulage effectué lors de l'étape c) est assurée dans un premier temps par la première couche d'encapsulation formée lors de l'étape b). Le meulage effectué lors de l'étape c) conduit généralement à une dégradation des flancs de la première couche d'encapsulation. La deuxième couche d'encapsulation formée lors de l'étape d) permet de protéger à nouveau efficacement les flancs des puces électroniques (et donc les flancs de la couche active) en vue des étapes ultérieures du procédé selon l'invention, en particulier l'étape f).

L'étape e) permet de mettre à nu la partie restante du substrat initial en vue d'effectuer une gravure chimique sélective. L'étape e) est une gravure directionnelle de manière à conserver la deuxième couche d'encapsulation pour protéger les flancs des puces électroniques (et donc les flancs de la couche active) lors de l'étape f).

L'étape f) permet de retirer efficacement la partie restante du substrat initial (moins de résidus par rapport à l'état de la technique) tout en maintenant intacte la couche active. En effet, la partie supérieure de la couche active est protégée par la couche diélectrique qui forme une couche d'arrêt de gravure. Les parties latérales de la couche active sont protégées par la deuxième couche d'encapsulation qui forme également une couche d'arrêt de gravure.

Le procédé selon l'invention peut comporter une ou plusieurs des caractéristiques suivantes.

Selon une caractéristique de l'invention, le procédé comporte une étape g) aplanir l'empilement obtenu à l'issue de l'étape f), l'étape g) étant de préférence exécutée par un polissage mécano-chimique ou par un meulage.

Ainsi, un avantage procuré est de retirer les parties saillantes de la deuxième couche d'encapsulation (par rapport à la surface libre de la partie restante du substrat initial) apparaissant à l'issue de l'étape e).

Selon une caractéristique de l'invention, la première couche d'encapsulation formée lors de l'étape b) présente une épaisseur comprise entre 500 nm et 2 µm.

Ainsi, un avantage procuré est d'obtenir un compromis satisfaisant entre efficacité de protection et temps d'opération.

Selon une caractéristique de l'invention, les premier et deuxième matériaux diélectriques des première et deuxième couches d'encapsulation formées respectivement lors des étapes b) et d) sont choisis parmi un polyépoxyde, le dioxyde de silicium, un matériau multicouche comprenant le nitrure de silicium et le dioxyde de silicium.

Selon une caractéristique de l'invention, les premier et deuxième matériaux diélectriques des première et deuxième couches d'encapsulation formées respectivement lors des étapes b) et d) sont identiques.

Ainsi, un avantage procuré est de simplifier la mise en œuvre du procédé.

Selon une caractéristique de l'invention, le deuxième matériau diélectrique de la deuxième couche d'encapsulation formée lors de l'étape d) est identique au matériau de la couche diélectrique des puces électroniques de l'empilement utilisé lors de l'étape a).

Ainsi, un avantage procuré est d'accroître les options pour le choix d'un agent de gravure autorisant une gravure sélective de la partie restante du substrat initial par rapport à la deuxième couche d'encapsulation et par rapport à la couche diélectrique. En d'autres termes, l'agent de gravure doit simplement autoriser une gravure sélective entre un premier matériau (substrat initial) et un second matériau (deuxième couche d'encapsulation et couche diélectrique).

Selon une caractéristique de l'invention, les puces électroniques de l'empilement utilisé lors de l'étape a) sont choisies parmi des capteurs d'image et des puces radiofréquence. D'autres applications sont bien entendu envisageables.

Selon une caractéristique de l'invention, la couche active comporte une pluralité de sous-couches semi-conductrices, chaque sous-couche semi-conductrice étant de préférence réalisée dans un matériau de type III-V.

Selon une caractéristique de l'invention, la gravure directionnelle effectuée lors de l'étape e) est une gravure sèche par plasma.

Ainsi, un avantage procuré est la simplicité de mise en œuvre du procédé.

Selon une caractéristique de l'invention :
- le substrat initial des puces électroniques de l'empilement utilisé lors de l'étape a) est réalisé en silicium ;
- la couche diélectrique des puces électroniques de l'empilement utilisé lors de l'étape a) est réalisée en dioxyde de silicium ;
- le deuxième matériau diélectrique de la deuxième couche d'encapsulation formée lors de l'étape d) est le dioxyde de silicium ;
- l'agent de gravure chimique avec lequel est exécutée l'étape f) est l'hydroxyde de tétraméthylammonium.

### Définitions

- Par « couche active », on entend une couche assurant la fonction principale de la puce électronique, par exemple la fonction de photosensibilité dans le cas d'un capteur d'images.
- Par « couche », on entend une unique couche ou une pluralité de sous-couches de même nature.
- Par « puce électronique » (« *die* » ou « *chip* » en langue anglaise), on entend un composant électronique, comportant un substrat (appelé substrat initial) ayant subi des étapes technologiques en vue de former ledit composant électronique.
- Par « substrat », on entend un support physique autoporté, réalisé dans un matériau de base à partir duquel peut être formé un dispositif pour tout type d'applications, notamment électronique, mécanique, optique. Un substrat peut être une « tranche », également dénommée « plaquette » (« *wafer* » en langue anglaise), qui se présente généralement sous la forme d'un disque issu d'une découpe dans un lingot d'un matériau cristallin.
- Par « successivement », on entend que les éléments de l'empilement sont disposés les uns sur les autres selon un ordre défini de bas en haut dans des conditions normales d'utilisation, c'est-à-dire suivant la normale à la surface du substrat support recevant les puces électroniques de manière générale.
- Par « interface de collage hybride », on entend une zone de contact entre le substrat support et la couche active, conçue pour autoriser à la fois un collage direct métal/métal et un collage direct diélectrique/diélectrique. La zone de contact peut comporter :
   (i) une première structure d'interconnexions, formée sur la surface libre du substrat support ;
   (ii) une deuxième structure d'interconnexions, sur laquelle sont formées les puces électroniques.

L'interface de collage hybride est alors la surface de contact entre les première et deuxième structures d'interconnexions.
- Par « structure d'interconnexions », on entend un empilement de niveaux d'interconnexions, comprenant des pistes métalliques noyées dans un matériau diélectrique.
- Le terme « meulage » est désigné par le terme « *grinding* » en langue anglaise.
- Par « gravure directionnelle », on entend une gravure anisotrope s'opérant sur une direction privilégiée, en l'espèce suivant la normale à la surface du substrat support recevant les puces électroniques.
- Par « flancs », on entend les parties latérales des puces électroniques. Chaque puce électronique comporte des parties supérieure et inférieure opposées, reliées entre elles par les parties latérales.
- Par « gravure sélective », on entend que la partie à graver du substrat initial (i.e. la partie restante du substrat initial conservée lors de l'étape c)) peut être gravée lors de l'étape f) sans attaquer la deuxième couche d'encapsulation et la couche diélectrique. En pratique, l'agent de gravure est généralement choisi de sorte que la vitesse de gravure de la partie à graver du substrat initial est au moins 3 fois supérieure (de préférence au moins 5 fois supérieure, plus préférentiellement au moins 10 fois supérieure) à la vitesse de gravure de la deuxième couche d'encapsulation et de la couche diélectrique.
- Par « polissage mécano-chimique » (CMP pour « *Chemical Mechanical Polishing* » en langue anglaise), on entend un procédé de polissage utilisant :
   (i) un tampon de polissage, mis en contact avec la surface libre de l'empilement, le tampon de polissage et la surface libre de l'empilement étant généralement mobiles en rotation autour d'axes de rotation parallèles (interaction mécanique) ;
   (ii) une solution de polissage, généralement abrasive et corrosive, imprégnant le tampon de polissage (interaction chimique).
- Par « épaisseur », on entend une dimension suivant la normale à la surface du substrat support recevant les puces électroniques.
- Par « matériaux identiques », on entend que la matière composant les matériaux est la même, les épaisseurs des matériaux dits identiques pouvant être différentes.
- Par « matériau de type III-V », on entend un alliage binaire entre des éléments situés respectivement dans la colonne III et dans la colonne V du tableau périodique des éléments.
- Les valeurs X et Y, exprimées à l'aide des expressions « entre X et Y » ou « compris entre X et Y », sont incluses dans la plage de valeurs définie.

### Brève description des dessins

D'autres caractéristiques et avantages apparaîtront dans l'exposé détaillé de différents modes de réalisation de l'invention, l'exposé étant assorti d'exemples et de références aux dessins joints.

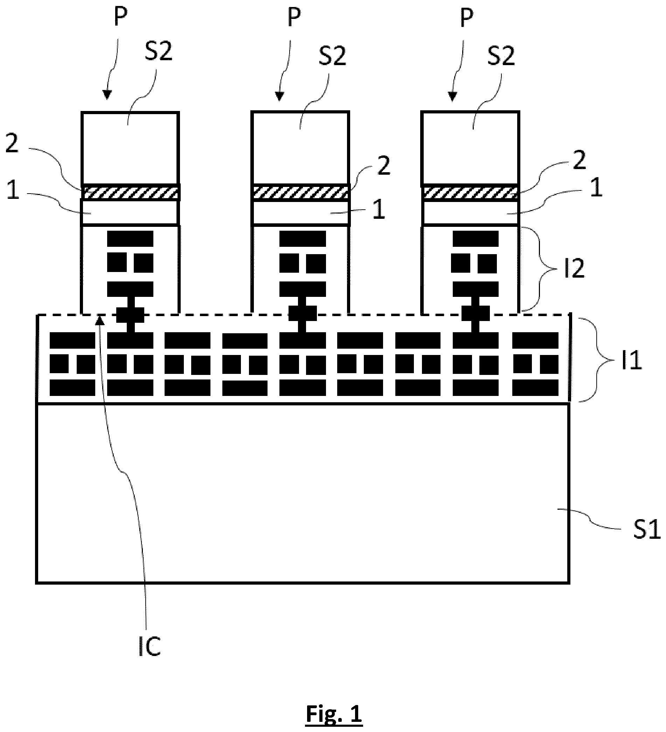

Figure 1 est une vue schématique en coupe, illustrant l'étape a) d'un procédé selon l'invention.

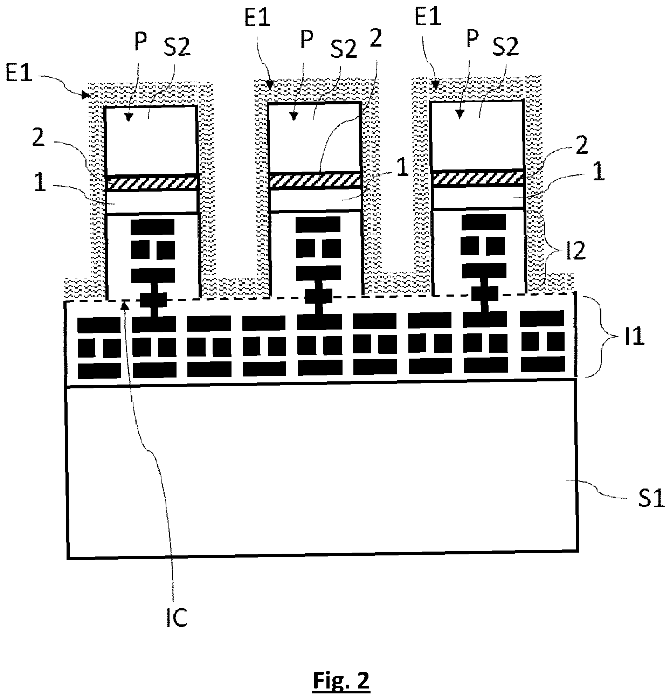

Figure 2 est une vue schématique en coupe, illustrant l'étape b) d'un procédé selon l'invention.

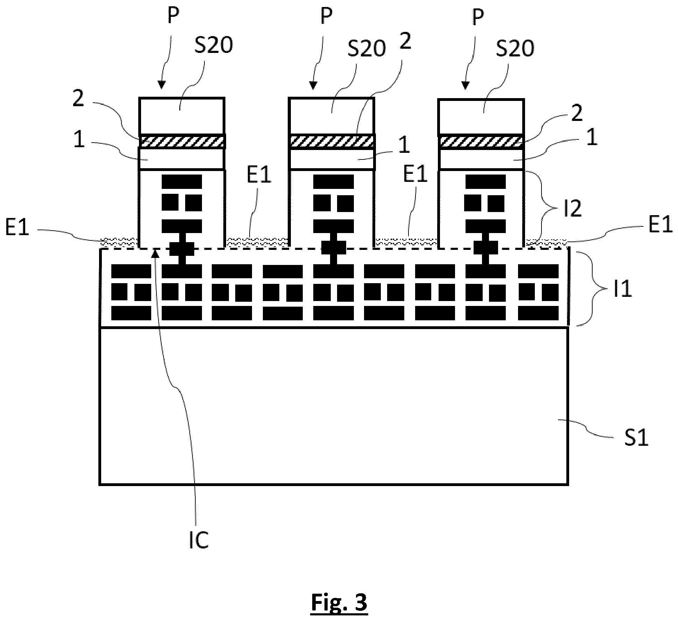

Figure 3 est une vue schématique en coupe, illustrant l'étape c) d'un procédé selon l'invention. Cette figure représente le cas où le meulage effectué lors de l'étape c) a entièrement supprimé des parties latérales de la première couche d'encapsulation s'étendant sur les parties latérales des puces électroniques. En pratique, le meulage effectué lors de l'étape c) peut laisser subsister une portion des parties latérales de la première couche d'encapsulation s'étendant sur les parties latérales des puces électroniques.

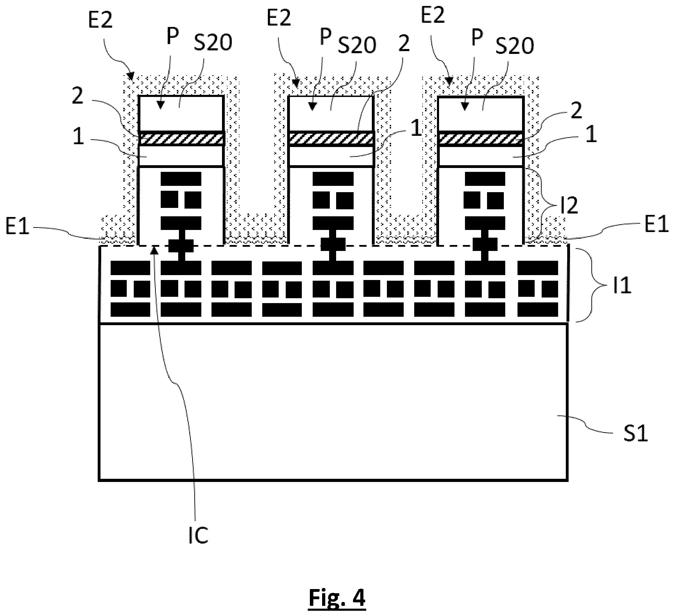

Figure 4 est une vue schématique en coupe, illustrant l'étape d) d'un procédé selon l'invention.

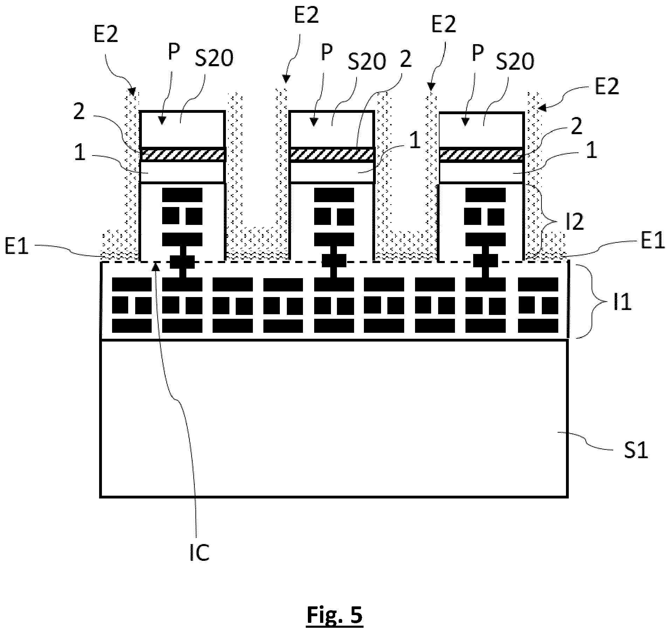

Figure 5 est une vue schématique en coupe, illustrant l'étape e) d'un procédé selon l'invention.

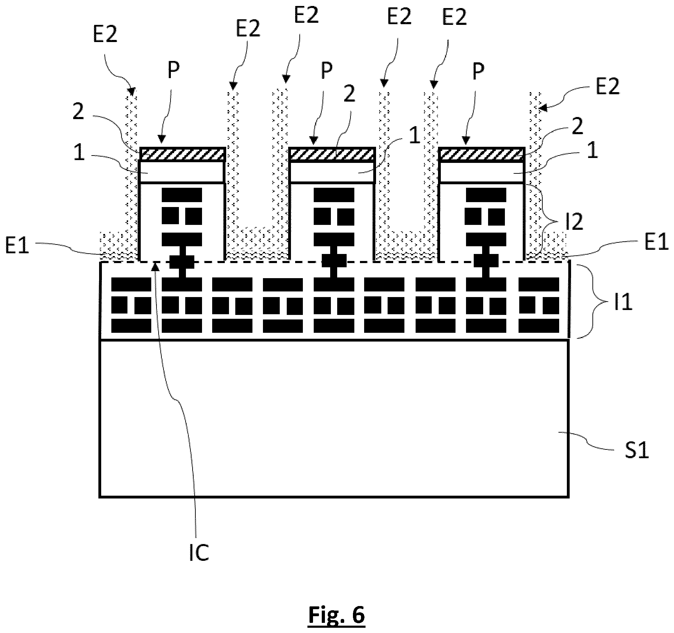

Figure 6 est une vue schématique en coupe, illustrant l'étape f) d'un procédé selon l'invention.

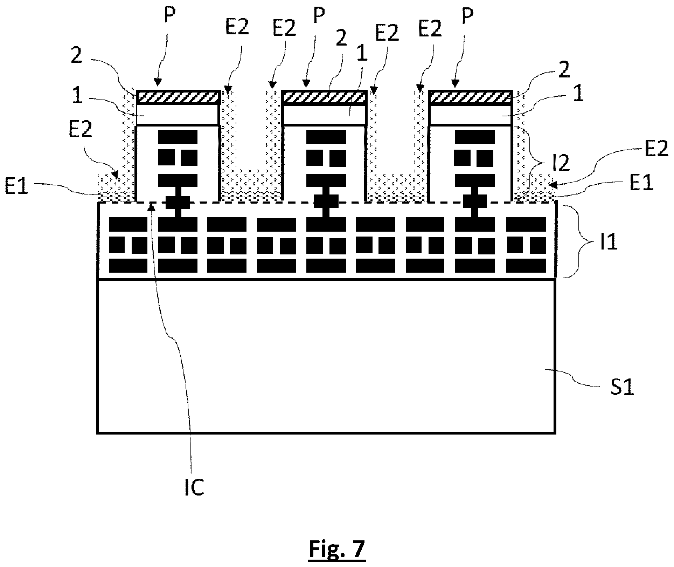

Figure 7 est une vue schématique en coupe, illustrant l'étape g) d'un procédé selon l'invention.

Il est à noter que les dessins décrits ci-avant sont schématiques, et ne sont pas nécessairement à l'échelle par souci de lisibilité et pour en simplifier leur compréhension. En particulier, les structures d'interconnexions dessinées sont simplifiées et ne montrent pas la réalité des interconnexions des pistes métalliques. Les coupes sont effectuées selon la normale à la surface du substrat support recevant les puces électroniques. Les traits pointillés représentent l'interface de collage hybride.

### Exposé détaillé des modes de réalisation

Les éléments identiques ou assurant la même fonction porteront les mêmes références pour les différents modes de réalisation, par souci de simplification.

Un objet de l'invention est un procédé de protection de couches actives 1 de puces électroniques P, comportant les étapes successives :
a) utiliser un empilement comprenant successivement :
   - un substrat support S1 ;
   - une interface de collage hybride IC, possédant un matériau métallique et un matériau diélectrique ;
   - des puces électroniques P, assemblées au substrat support S1 via l'interface de collage hybride IC, et comprenant chacune successivement une couche active 1, une couche diélectrique 2 et un substrat initial S2 ;
b) former une première couche d'encapsulation E1 autour des puces électroniques P, la première couche d'encapsulation E1 étant réalisée dans un premier matériau diélectrique ;
c) effectuer un meulage de manière à retirer une partie du substrat initial S2 de chacune des puces électroniques P et conserver une partie restante S20 dudit substrat initial S2 ;
d) former une deuxième couche d'encapsulation E2 autour des puces électroniques P, la deuxième couche d'encapsulation E2 étant réalisée dans un deuxième matériau diélectrique ;
e) effectuer une gravure directionnelle d'une partie de la deuxième couche d'encapsulation E2, s'étendant sur la partie restante S20 du substrat initial S2 de chacune des puces électroniques P, de manière à :
   - exposer superficiellement la partie restante S20 du substrat initial S2 de chacune des puces électroniques P ;
   - conserver la deuxième couche d'encapsulation E2 s'étendant sur les flancs des puces électroniques P ;
f) effectuer une gravure chimique sélective de la partie restante S20 du substrat initial S2 de chacune des puces électroniques P ; l'étape f) étant exécutée avec un agent de gravure chimique autorisant une gravure sélective de la partie restante S20 du substrat initial S2 par rapport à la deuxième couche d'encapsulation E2 et par rapport à la couche diélectrique 2.

### Etape a)

L'empilement utilisé lors de l'étape a) comprend successivement :
- un substrat support S1 ;
- une interface de collage hybride IC, possédant un matériau métallique et un matériau diélectrique ;
- des puces électroniques P, assemblées au substrat support S1 via l'interface de collage hybride IC, et comprenant chacune successivement une couche active 1, une couche diélectrique 2 et un substrat initial S2.

A titre d'exemple non limitatif, le substrat support S1 peut être réalisé en silicium.

L'interface de collage hybride IC est une zone de contact entre le substrat support S1 et la couche active 1 de chacune des puces électroniques P. La zone de contact est conçue pour autoriser à la fois un collage direct métal/métal et un collage direct diélectrique/diélectrique. La zone de contact peut comporter :
- une première structure d'interconnexions I1, formée sur la surface libre du substrat support S1 ;
- une deuxième structure d'interconnexions I2, sur laquelle sont formées les puces électroniques P.

L'interface de collage hybride IC est alors la surface de contact entre les première et deuxième structures d'interconnexions I1, I2. A titre d'exemple non limitatif, le matériau métallique de l'interface de collage hybride IC peut être le cuivre. A titre d'exemple non limitatif, le matériau diélectrique de l'interface de collage hybride IC peut être le dioxyde de silicium.

A titre d'exemple non limitatif, la puce électronique P, munie de la deuxième structure d'interconnexions I2, peut présenter une épaisseur de l'ordre de 775 µm lors de l'étape a).

La couche active 1, la couche diélectrique 2 et le substrat initial S2 de chacune des puces électroniques P sont avantageusement issus d'un substrat avancé de type semi-conducteur sur isolant (SeOI pour « *Semiconductor-on-Insulator* » en langue anglaise), pouvant notamment être obtenu par la technique dénommée Smart-Cut ^{™}.

Les puces électroniques P peuvent être des capteurs d'image, notamment infrarouge. La couche active 1 comporte avantageusement une pluralité de sous-couches semi-conductrices, chaque sous-couche semi-conductrice étant de préférence réalisée dans un matériau de type III-V. A titre d'exemple non limitatif, la couche active 1 de chacune des puces électroniques P peut comporter successivement une première sous-couche de phosphure d'indium InP, une deuxième sous-couche d'arséniure de gallium GaAs, et une troisième sous-couche de phosphure d'indium InP.

Les puces électroniques P peuvent également être des puces radiofréquence (RF). D'autres applications sont bien entendu envisageables.

### Etape b)

La première couche d'encapsulation E1 est formée lors de l'étape b) autour des puces électroniques P. Le terme « autour » signifie que la première couche d'encapsulation E1 s'étend sur la partie supérieure et sur les parties latérales des puces électroniques P. L'étape b) est exécutée par une technique de dépôt permettant à la première couche d'encapsulation E1 de suivre la topographie de surface des puces électroniques P. Il n'est pas nécessaire que la technique de dépôt produise un dépôt dit conforme (taux de conformité égal à 100%). En d'autres termes, la technique de dépôt est choisie pour présenter un taux de conformité (ratio entre la largeur des flancs de la première couche d'encapsulation E1 déposée et l'épaisseur en surface de la première couche d'encapsulation E1 déposée) permettant de suivre la topographie de surface des puces électroniques P. A titre d'exemple non limitatif, la première couche d'encapsulation E1 peut être formée lors de l'étape b) par un dépôt chimique en phase vapeur.

La première couche d'encapsulation E1 est réalisée dans un premier matériau diélectrique. Le premier matériau diélectrique est avantageusement choisi parmi un polyépoxyde, le dioxyde de silicium, un matériau multicouche comprenant le nitrure de silicium et le dioxyde de silicium.

La première couche d'encapsulation E1 formée lors de l'étape b) présente avantageusement une épaisseur comprise entre 500 nm et 2 µm.

### Etape c)

Le meulage est effectué lors de l'étape c) de manière à retirer une partie du substrat initial S2 de chacune des puces électroniques P et conserver une partie restante S20 dudit substrat initial S2.

A titre d'exemple non limitatif, la puce électronique P, munie de la deuxième structure d'interconnexions I2, peut présenter une épaisseur de l'ordre de 10 µm à l'issue de l'étape c).

### Etape d)

La deuxième couche d'encapsulation E2 est formée lors de l'étape d) autour des puces électroniques P. Le terme « autour » signifie que la deuxième couche d'encapsulation E2 s'étend sur la partie supérieure et sur les parties latérales des puces électroniques P. Dans le cas où le meulage effectué lors de l'étape c) n'a pas entièrement supprimé des parties latérales de la première couche d'encapsulation E1 (s'étendant sur les parties latérales des puces électroniques P), la deuxième couche d'encapsulation E2 s'étend sur la partie supérieure des puces électroniques P et sur les parties latérales de la première couche d'encapsulation E1. L'étape d) est exécutée par une technique de dépôt permettant à la deuxième couche d'encapsulation E2 de suivre la topographie de surface des puces électroniques P. Il n'est pas nécessaire que la technique de dépôt produise un dépôt dit conforme (taux de conformité égal à 100%). En d'autres termes, la technique de dépôt est choisie pour présenter un taux de conformité (ratio entre la largeur des flancs de la deuxième couche d'encapsulation E2 déposée et l'épaisseur en surface de la deuxième couche d'encapsulation E2 déposée) permettant de suivre la topographie de surface des puces électroniques P. A titre d'exemple non limitatif, la deuxième couche d'encapsulation E2 peut être formée lors de l'étape d) par un dépôt chimique en phase vapeur.

La deuxième couche d'encapsulation E2 est réalisée dans un deuxième matériau diélectrique. Le deuxième matériau diélectrique est avantageusement choisi parmi un polyépoxyde, le dioxyde de silicium, un matériau multicouche comprenant le nitrure de silicium et le dioxyde de silicium. Le deuxième matériau diélectrique est avantageusement identique au premier matériau diélectrique. Le deuxième matériau diélectrique est avantageusement identique au matériau de la couche diélectrique 2 des puces électroniques P de l'empilement utilisé lors de l'étape a).

La deuxième couche d'encapsulation E2 formée lors de l'étape d) présente avantageusement une épaisseur comprise entre 500 nm et 2 µm.

### Etape e)

La gravure effectuée lors de l'étape e) est une gravure directionnelle d'une partie de la deuxième couche d'encapsulation E2, ladite partie s'étendant sur la partie restante S20 du substrat initial S2 de chacune des puces électroniques P.

La gravure directionnelle est effectuée lors de l'étape e) de manière à :
- exposer superficiellement la partie restante S20 du substrat initial S2 de chacune des puces électroniques P ;
- conserver la deuxième couche d'encapsulation E2 s'étendant sur les flancs des puces électroniques P.

La gravure directionnelle effectuée lors de l'étape e) est avantageusement une gravure sèche par plasma.

### Etape f)

La gravure effectuée lors de l'étape f) est une gravure chimique sélective de la partie restante S20 du substrat initial S2 de chacune des puces électroniques P.

L'étape f) est exécutée avec un agent de gravure chimique autorisant une gravure sélective de la partie restante S20 du substrat initial S2 par rapport à la deuxième couche d'encapsulation E2 et par rapport à la couche diélectrique 2.

A titre d'exemple non limitatif, la puce électronique P, munie de la deuxième structure d'interconnexions I2, peut présenter une épaisseur comprise entre 4 µm et 5 µm à l'issue de l'étape f).

### Etape g)

Le procédé comporte avantageusement une étape g) aplanir l'empilement obtenu à l'issue de l'étape f). L'étape g) est de préférence exécutée par un polissage mécano-chimique ou par un meulage.

### Etape h)

Le procédé comporte avantageusement une étape h) former des plots de contact électrique, électriquement connectés à l'interface de collage hybride IC. Les plots de contact électrique peuvent être formés sur la deuxième structure d'interconnexions I2. A titre d'exemples non limitatifs, les plots de contact électrique peuvent être réalisés en aluminium ou dans un alliage Cu/Ni/Au.

### Exemple de mise en œuvre

Le substrat initial S2 des puces électroniques P de l'empilement utilisé lors de l'étape a) est réalisé en silicium. La couche diélectrique 2 des puces électroniques P de l'empilement utilisé lors de l'étape a) est réalisée en dioxyde de silicium. Le deuxième matériau diélectrique de la deuxième couche d'encapsulation E2 formée lors de l'étape d) est le dioxyde de silicium. L'agent de gravure chimique avec lequel est exécutée l'étape f) est l'hydroxyde de tétraméthylammonium.

L'invention ne se limite pas aux modes de réalisation exposés, mais est définie uniquement par les revendications ci-jointes.

## Revendications

1. Procédé de protection de couches actives (1) de puces électroniques (P), comportant les étapes successives :
a) utiliser un empilement comprenant successivement :
- un substrat support (S1) ;
- une interface de collage hybride (IC), possédant un matériau métallique et un matériau diélectrique ;
- des puces électroniques (P), assemblées au substrat support (S1) via l'interface de collage hybride (IC), et comprenant chacune successivement une couche active (1), une couche diélectrique (2) et un substrat initial (S2) ;
b) former une première couche d'encapsulation (E1) autour des puces électroniques (P), la première couche d'encapsulation (E1) étant réalisée dans un premier matériau diélectrique ;
c) effectuer un meulage de manière à retirer une partie du substrat initial (S2) de chacune des puces électroniques (P) et conserver une partie restante (S20) dudit substrat initial (S2) ;
d) former une deuxième couche d'encapsulation (E2) autour des puces électroniques (P), la deuxième couche d'encapsulation (E2) étant réalisée dans un deuxième matériau diélectrique ;
e) effectuer une gravure directionnelle d'une partie de la deuxième couche d'encapsulation (E2), s'étendant sur la partie restante (S20) du substrat initial (S2) de chacune des puces électroniques (P), de manière à :
- exposer superficiellement la partie restante (S20) du substrat initial (S2) de chacune des puces électroniques (P) ;
- conserver la deuxième couche d'encapsulation (E2) s'étendant sur les flancs des puces électroniques (P) ;
f) effectuer une gravure chimique sélective de la partie restante (S20) du substrat initial (S2) de chacune des puces électroniques (P) ; l'étape f) étant exécutée avec un agent de gravure chimique autorisant une gravure sélective de la partie restante (S20) du substrat initial (S2) par rapport à la deuxième couche d'encapsulation (E2) et par rapport à la couche diélectrique (2).

2. Procédé selon la revendication 1, comportant une étape g) aplanir l'empilement obtenu à l'issue de l'étape f), l'étape g) étant de préférence exécutée par un polissage mécano-chimique ou par un meulage.

3. Procédé selon la revendication 1 ou 2, dans lequel la première couche d'encapsulation (E1) formée lors de l'étape b) présente une épaisseur comprise entre 500 nm et 2 µm.

4. Procédé selon l'une des revendications 1 à 3, dans lequel les premier et deuxième matériaux diélectriques des première et deuxième couches d'encapsulation (E1, E2) formées respectivement lors des étapes b) et d) sont choisis parmi un polyépoxyde, le dioxyde de silicium, un matériau multicouche comprenant le nitrure de silicium et le dioxyde de silicium.

5. Procédé selon l'une des revendications 1 à 4, dans lequel les premier et deuxième matériaux diélectriques des première et deuxième couches d'encapsulation (E1, E2) formées respectivement lors des étapes b) et d) sont identiques.

6. Procédé selon l'une des revendications 1 à 5, dans lequel le deuxième matériau diélectrique de la deuxième couche d'encapsulation (E2) formée lors de l'étape d) est identique au matériau de la couche diélectrique (2) des puces électroniques (P) de l'empilement utilisé lors de l'étape a).

7. Procédé selon l'une des revendications 1 à 6, dans lequel les puces électroniques (P) de l'empilement utilisé lors de l'étape a) sont choisies parmi des capteurs d'image et des puces radiofréquence.

8. Procédé selon l'une des revendications 1 à 7, dans lequel la couche active (1) comporte une pluralité de sous-couches semi-conductrices, chaque sous-couche semi-conductrice étant de préférence réalisée dans un matériau de type III-V.

9. Procédé selon l'une des revendications 1 à 8, dans lequel la gravure directionnelle effectuée lors de l'étape e) est une gravure sèche par plasma.

10. Procédé selon l'une des revendications 1 à 9, dans lequel :
- le substrat initial (S2) des puces électroniques (P) de l'empilement utilisé lors de l'étape a) est réalisé en silicium ;
- la couche diélectrique (2) des puces électroniques (P) de l'empilement utilisé lors de l'étape a) est réalisée en dioxyde de silicium ;
- le deuxième matériau diélectrique de la deuxième couche d'encapsulation (E2) formée lors de l'étape d) est le dioxyde de silicium ;
- l'agent de gravure chimique avec lequel est exécutée l'étape f) est l'hydroxyde de tétraméthylammonium.

## Patentansprüche

1. Verfahren zum Schützen von aktiven Schichten (1) von elektronischen Chips (P), umfassend die folgenden Schritte:
a) Verwenden eines Stapels, umfassend nacheinander:
- ein Trägersubstrat (S1);
- eine Hybrid-Bonding-Schnittstelle (IC), die ein metallisches Material und ein dielektrisches Material besitzt;
- elektronische Chips (P), die über die Hybrid-Bonding-Schnittstelle (IC) mit dem Trägersubstrat (S1) verbunden sind und jeweils nacheinander eine aktive Schicht (1), eine dielektrische Schicht (2) und ein Ausgangssubstrat (S2) umfassen;
b) Bilden einer ersten Kapselungsschicht (E1) um die elektronischen Chips (P), wobei die erste Kapselungsschicht (E1) aus einem ersten dielektrischen Material ausgeführt ist;
c) Durchführen eines Schleifens, so dass ein Teil des Ausgangssubstrats (S2) von jedem der elektronischen Chips (P) entfernt wird und ein restlicher Teil (S20) des Ausgangssubstrats (S2) erhalten bleibt;
d) Bilden einer zweiten Kapselungsschicht (E2) um die elektronischen Chips (P), wobei die zweite Kapselungsschicht (E2) aus einem zweiten dielektrischen Material ausgeführt ist;
e) Durchführen eines gerichteten Ätzens eines Teils der zweiten Kapselungsschicht (E2), der sich auf dem restlichen Teil (S20) des Ausgangssubstrats (S2) jedes der elektronischen Chips (P) erstreckt, so dass:
- der restliche Teil (S20) des Ausgangssubstrats (S2) jedes der elektronischen Chips (P) oberflächlich freigelegt wird;
- die zweite Kapselungsschicht (E2), die sich auf den Flanken der elektronischen Chips (P) erstreckt, erhalten bleibt;
f) Durchführen eines selektiven chemischen Ätzens des restlichen Teils (S20) des Ausgangssubstrats (S2) jedes der elektronischen Chips (P); wobei der Schritt f) mit einem chemischen Ätzmittel ausgeführt wird, das ein selektives Ätzen des restlichen Teil (S20) des Ausgangssubstrats (S2) in Bezug auf die zweite Kapselungsschicht (E2) und in Bezug auf die dielektrische Schicht (2) zulässt.

2. Verfahren nach Anspruch 1, umfassend einen Schritt g) des Planarisierens des am Ende des Schritts f) erhaltenen Stapels, wobei der Schritt g) vorzugsweise durch ein chemisch-mechanisches Polieren oder durch ein Schleifen ausgeführt wird.

3. Verfahren nach einem der Ansprüche 1 oder 2, wobei die bei dem Schritt b) gebildete erste Kapselungsschicht (E1) eine Dicke zwischen 500 nm und 2 µm aufweist.

4. Verfahren nach einem der Ansprüche 1 bis 3, wobei das erste und das zweite dielektrische Material der ersten und der zweiten Kapselungsschicht (E1, E2), die bei den Schritten b) bzw. d) gebildet werden, aus einem Polyepoxid, Siliciumdioxid, einem mehrschichtigen Material, das Siliciumnitrid und Siliciumdioxid umfasst, ausgewählt sind.

5. Verfahren nach einem der Ansprüche 1 bis 4, wobei das erste und das zweite dielektrische Material der ersten und der zweiten Kapselungsschicht (E1, E2), die bei den Schritten b) bzw. d) gebildet werden, identisch sind.

6. Verfahren nach einem der Ansprüche 1 bis 5, wobei das zweite dielektrische Material der beim Schritt d) gebildeten zweiten Kapselungsschicht (E2) mit dem Material der dielektrischen Schicht (2) der elektronischen Chips (P) des beim Schritt a) verwendeten Stapels identisch ist.

7. Verfahren nach einem der Ansprüche 1 bis 6, wobei die elektronischen Chips (P) des beim Schritt a) verwendeten Stapels aus Bildsensoren und Hochfrequenz-Chips ausgewählt sind.

8. Verfahren nach einem der Ansprüche 1 bis 7, wobei die aktive Schicht (1) eine Mehrzahl von Halbleiterteilschichten umfasst, wobei jede Halbleiterteilschicht vorzugsweise aus einem Material vom Typ III-V ausgeführt ist

9. Verfahren nach einem der Ansprüche 1 bis 8, wobei das beim Schritt e) durchgeführte gerichtete Ätzen ein Plasma-Trockenätzen ist.

10. Verfahren nach einem der Ansprüche 1 bis 9, wobei:
- das Ausgangssubstrat (S2) der elektronischen Chips (P) des beim Schritt a) verwendeten Stapels aus Silicium ausgeführt ist;
- die dielektrische Schicht (2) der elektronischen Chips (P) des beim Schritt a) verwendeten Stapels aus Siliciumdioxid ausgeführt ist;
- das zweite dielektrische Material der zweiten Kapselungsschicht (E2), die beim Schritt d) gebildet wird, Siliciumdioxid ist;
- das chemische Ätzmittel, mit dem der Schritt f) ausgeführt wird, Tetramethylammoniumhydroxid ist.

## Claims

1. Method for protecting active layers (1) of electronic chips (P) including the following successive steps:
a) using a stack comprising, successively:
- a carrier substrate (S1),
- a hybrid bonding interface (IC) having a metal material and a dielectric material,
- electronic chips (P) assembled on the carrier substrate (S1) via the hybrid bonding interface (IC), each comprising successively an active layer (1), a dielectric layer (2) and an initial substrate (S2),
b) forming a first encapsulating layer (E1) about the electronic chips (P), the first encapsulating layer (E1) being made of a first dielectric material,
c) removing a part of the initial substrate (S2) from each of the electronic chips (P) by grinding and preserving a remaining part (S20) of said initial substrate (S2),
d) forming a second encapsulating layer (E2) about the electronic chips (P), the second encapsulating layer (E2) being made of a second dielectric material,
e) performing a directional etch of a part of the second encapsulating layer (E2) extending over the remaining part (S20) of the initial substrate (S2) of each of the electronic chips (P) to:
- superficially expose the remaining part (S20) of the initial substrate (S2) of each of the electronic chips (P),
- preserve the second encapsulating layer (E2) extending over the flanks of the electronic chips (P),
f) performing a selective chemical etch of the remaining part (S20) of the initial substrate (S2) of each of the electronic chips (P), step f) being carried out with a chemical etchant that permits selective etching of the remaining part (S20) of the initial substrate (S2) with respect to the second encapsulating layer (E2) and with respect to the dielectric layer (2).

2. Method according to Claim 1, including a step g) of planarizing the stack obtained on completion of step f), step g) preferably being carried out by chemical mechanical polishing or by grinding.

3. Method according to Claim 1 or 2, wherein the first encapsulating layer (E1) formed during step b) has a thickness of between 500 nm and 2 µm.

4. Method according to one of Claims 1 to 3, wherein the first and second dielectric materials of the first and second encapsulating layers (E1, E2) formed respectively during steps b) and d) are chosen from a polyepoxide, silicon dioxide, a multilayer material comprising silicon nitride and silicon dioxide.

5. Method according to one of Claims 1 to 4, wherein the first and second dielectric materials of the first and second encapsulating layers (E1, E2) formed respectively during steps b) and d) are identical.

6. Method according to one of Claims 1 to 5, wherein the second dielectric material of the second encapsulating layer (E2) formed during step d) is identical to the material of the dielectric layer (2) of the electronic chips (P) of the stack used during step a).

7. Method according to one of Claims 1 to 6, wherein the electronic chips (P) of the stack used in step a) are chosen from image sensors and radio frequency chips.

8. Method according to one of Claims 1 to 7, wherein the active layer (1) includes a plurality of semiconductor sublayers, each semiconductor sublayer preferably being made of a III-V material.

9. Method according to one of Claims 1 to 8, wherein the directional etch carried out during step e) is a dry plasma etch.

10. Method according to one of Claims 1 to 9, wherein:
- the initial substrate (S2) of the electronic chips (P) of the stack used during step a) is made of silicon,
- the dielectric layer (2) of the electronic chips (P) of the stack used during step a) is made of silicon dioxide,
- the second dielectric material of the second encapsulating layer (E2) formed during step d) is silicon dioxide,
- the chemical etchant used to carry out step f) is tetramethylammonium hydroxide.
